# EUROPEAN PATENT APPLICATION

(11) **EP 4 757 189 A1**
(43) Date of publication of application: **10.06.2026**
(21) Application number: 24856680.4
(22) Date of filing: 29.07.2024
(51) Int. Cl.: H04B 1/40, H02M 1/00, H02M 3/156, H03F 1/02, H03F 3/195, H01Q 5/30, H04B 1/04

(54) **POWER SUPPLY MODULE AND ELECTRONIC DEVICE COMPRISING SAME**

(30) Priority: 23.08.2023 KR 20230110903; 19.09.2023 KR 20230125156
(71) Applicant: Samsung Electronics Co., Ltd., Suwon-si, Gyeonggi-do 16677 (KR)
(72) Inventor: KANG, Hyunsang, Suwon-si Gyeonggi-do 16677 (KR); NA, Hyoseok, Suwon-si Gyeonggi-do 16677 (KR); MOON, Yohan, Suwon-si Gyeonggi-do 16677 (KR)
(74) Representative: HGF
(86) International application number: PCT/KR2024/011053
(87) International publication number: WO 2025/042067

(57) **Abstract**

In embodiments, an electronic device is provided. The electronic device may comprise: a processor; a radio frequency (RF) transceiver; a first radio frequency front end (RFFE) module including a first power amplifier; a second RFFE module including a second power amplifier; and a power supply module including a first power supply circuit for the first power amplifier, a second power supply circuit for the second power amplifier, a linear regulator, and a switching circuit configured to selectively connect an output of the linear regulator to the first power supply circuit or the second power supply circuit.

## Description

### [Technical Field]

The following descriptions relate to a power supply module and an electronic device including the power supply module.

### [Background Art]

An electronic device may include radio frequency front end (RFFE) modules for transmitting or receiving a signal. For example, an RFFE module may include a power amplifier (PA) for transmit power of a signal to be transmitted through an antenna connected to the RFFE module. The PA may obtain the transmission power based on power from a power supply module.

The above-described information may be provided as a related art for the purpose of helping understanding of the present disclosure. No argument or decision is made as to whether any of the above description may be applied as a prior art related to the present disclosure.

### [Disclosure]

### [Technical Solution]

In embodiments, an electronic device is provided. The electronic device may comprise a processor, a radio frequency (RF) transceiver, a first radio frequency front end (RFFE) module including a first power amplifier, a second RFFE module including a second power amplifier, and a power supply module including a first power supply circuit for the first power amplifier, a second power supply circuit for the second power amplifier, a linear regulator, and a switching circuit configured to connect an output of the linear regulator to the first power supply circuit or the second power supply circuit selectively. The processor may be configured to, in a first state, control the switching circuit to provide, while providing a first supply voltage to the first power amplifier through the power supply module based on an envelope tracking (ET) mode using the linear regulator and the first power supply circuit, a second supply voltage to the second power amplifier through the power supply module based on an average power tracking (APT) mode using the second power supply circuit. The processor may be configured to, in a second state, control the switching circuit to provide, while providing the first supply voltage to the first power amplifier through the power supply module based on an APT mode using the first power supply circuit, the second supply voltage to the second power amplifier through the power supply module based on an ET mode using the linear regulator and the second power supply circuit.

In embodiments, a power supply module is provided. The power supply module may comprise a first power supply circuit including a first buck converter circuit and a first boost converter circuit for the first buck converter circuit, a second power supply circuit including a second buck converter circuit and a second boost converter circuit for the second buck converter circuit, a linear regulator, and a switching circuit configured to selectively operate in one of a first state and a second state based on a control signal. The first boost converter circuit may be configured to provide a regulator voltage to the first linear regulator. The switching circuit may be configured to, in the first state, connect the first buck converter circuit of the first power supply circuit to an output of the linear regulator. The switching circuit may be configured to, in the second state, connect the second buck converter circuit of the second power supply circuit to an output of the linear regulator.

In embodiments, an electronic device is provided. The electronic device may comprise a processor, a radio frequency (RF) transceiver, a first radio frequency front end (RFFE) module including a first power amplifier, a second RFFE module including a second power amplifier, and a power supply module including a first power supply circuit for the first power amplifier, a second power supply circuit for the second power amplifier, a linear regulator, and a switching circuit configured to connect an output of the linear regulator to the first power supply circuit or the second power supply circuit selectively. The switching circuit may be controlled, in accordance with the processor or the RF transceiver, to, in a first state, provide, while providing a first supply voltage to the first power amplifier through the power supply module based on an envelope tracking (ET) mode using the linear regulator and the first power supply circuit, a second supply voltage to the second power amplifier through the power supply module based on an average power tracking (APT) mode using the second power supply circuit. The switching circuit may be controlled, in accordance with the processor or the RF transceiver, to, in a second state, provide, while providing the first supply voltage to the first power amplifier through the power supply module based on an APT mode using the first power supply circuit, the second supply voltage to the second power amplifier through the power supply module based on an ET mode using the linear regulator and the second power supply circuit.

### [Description of the Drawings]

FIG. 1 is a block diagram of an electronic device in a network environment.
FIGS. 2A and 2B are diagrams for describing an envelope tracking (ET) mode and an average power tracking (APT) mode.
FIG. 3 represents an example of an electronic device including a power supply module.
FIGS. 4A to 4B represent examples of a power supply module including a switching circuit.
FIGS. 5A to 5B represent examples of control of a switching circuit of a power supply module.
FIGS. 6A to 6B represent examples of control of a switching circuit of a power supply module in accordance with a transmission power.
FIGS. 7A to 7B represent examples of control of a switching circuit of a power supply module in accordance with a bandwidth.
FIGS. 8A to 8B represent examples of control of a switching circuit of a power supply module in accordance with a bandwidth.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

A term referring to a part of an electronic device (e.g., a communication module, a wireless communication module, a substrate, a printed circuit board (PCB), a flexible PCB (FPCB), a module, an antenna, an antenna element, a circuit, a processor, a chip, a component, or a device), a term referring to an RF-related component (e.g., a front end module (FEM), a power amplifier module (PAM), a FEM including duplexer (FEMid), a power amplifier module including duplexer (PAMid), a Low noise amplifier PAM including duplexer (LPAMid), a radio frequency front end (RFFE), or a radio frequency integrated circuit (RFIC)), a term referring to a shape of a component (e.g., a structure, a structural body, a support portion, a contact portion, or a protrusion), a term referring to a connection portion between structures (e.g., a connection portion, a contact portion, a support portion, a contact structure, a conductive member, or an assembly), a term referring to a circuit (e.g., a PCB, an FPCB, a signal line, a feeding line, a data line, an RF signal line, an antenna line, a signal path, an RF path, an RF module, an RF circuit, a splitter, a divider, a coupler, or a combiner), and the like used in the following descriptions are exemplified for convenience of description. Therefore, the present disclosure is not limited to terms to be described below, and another term having an equivalent technical meaning may be used. In addition, a term such as "...unit", '...device', '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

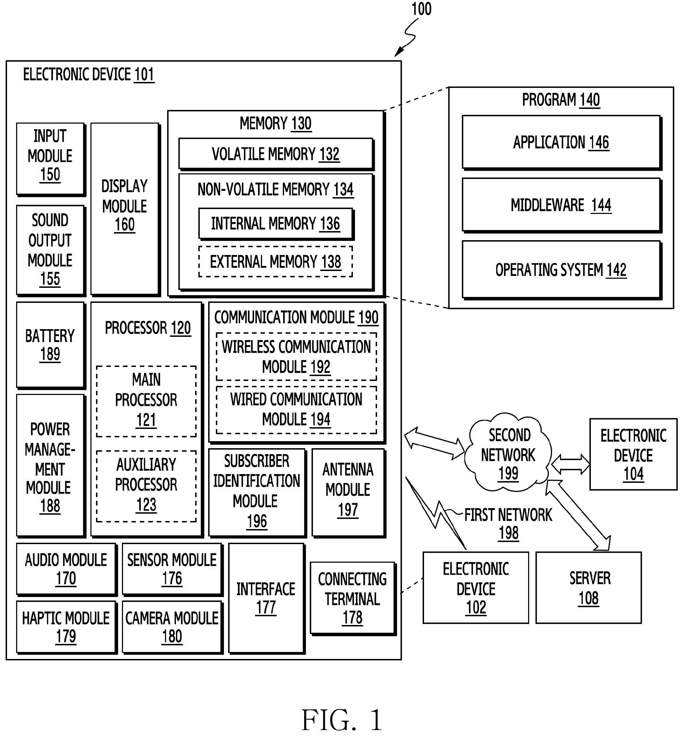

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

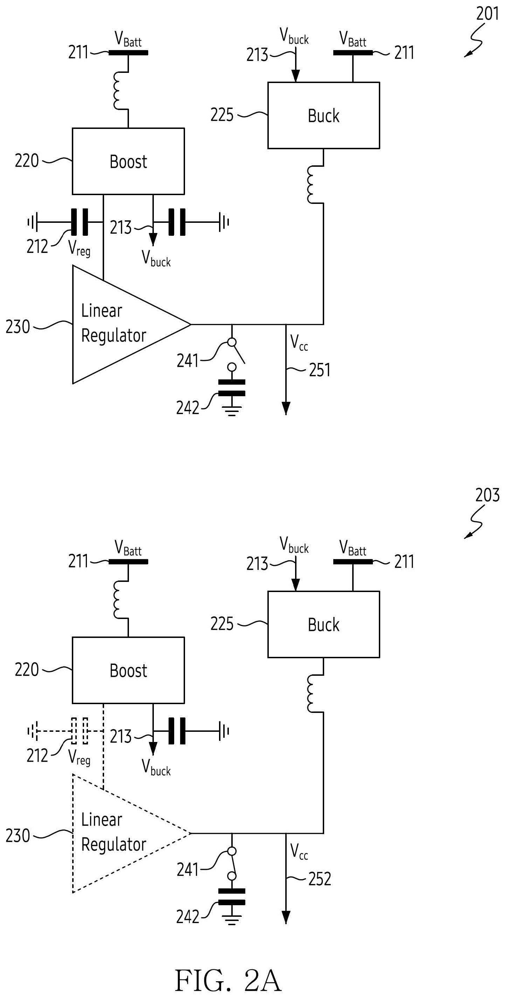

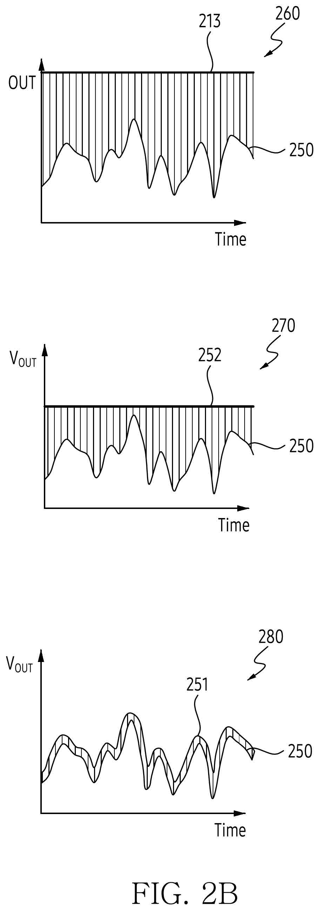

FIGS. 2A and 2B are diagrams for describing an envelope tracking (ET) mode and an average power tracking (APT) mode. In an electronic device (e.g., the electronic device 101 of FIG. 1), a current consumed by a power amplifier (PA) affects battery usage time of a user of the electronic device 101. Multiple technologies are being used to reduce current consumption by the power amplifier. In addition, as a peak-to-average power ratio (PAPR) increases due to introduction of a communication technology using OFDM (e.g., LTE or NR), high efficiency is required. In order to reduce the current consumption of the power amplifier and satisfy the high efficiency, through a power supply module, the electronic device 101 may supply power to the power amplifier using an ET method or may supply power using an APT method.

Referring to FIG. 2A, an example of a power supply circuit operable in an ET mode or an APT mode is described as at least a portion of the power supply module. The power supply circuit may include a boost converter circuit 220, a buck converter circuit 225, a linear regulator 230, an APT switch 241, and a capacitor 242. A battery voltage 211 may be supplied to the boost converter circuit 220. The buck converter circuit 225 used to describe embodiments in the present disclosure may include a circuit configured to perform a voltage drop in DC-DC converting. In addition to the buck converter circuit, terms such as a buck circuit, a buck block, a buck converter block, a step-down converter, a step-down circuit, a step-down block, or a large buck converter, and/or a term having equivalent technical/functional meaning may be used to refer to the buck converter circuit 225. The boost converter circuit 220 used to describe embodiments in the present disclosure may include a circuit configured to perform a voltage increase in DC-DC converting. In addition to the boost converter circuit, terms such as a boost circuit, a boost block, a boost converter block, a step-up converter, a step-up circuit, or a step-up block, and/or a term having equivalent technical/functional meaning may be used to refer to the boost converter circuit.

Referring to FIG. 2A, in a first example 201, the power supply circuit may operate in an ET mode. ET is a technology that supplies power to a power amplifier by a magnitude corresponding to an envelope of a transmission signal. In the first example 201, the linear regulator 230 may operate. In addition to an ET mode, terms such as an ET state, an ET operation, an ET method, an envelope reference mode, an envelope check mode, or an envelope use mode, and/or a term having equivalent technical/functional meaning may be used to refer to the ET mode. In the ET mode, the linear regulator 230 may use an envelope of a signal outputted from an RF transceiver as an input. The linear regulator 230 may be configured to amplify the envelope. The boost converter circuit 220 may be configured to output a regulator voltage 212 and a buck converter voltage 213 based on the battery voltage 211. An output of the linear regulator 230 may be connected to an output of the buck converter circuit 225. The buck converter circuit 225 may output a supply voltage 251 V_{cc} in accordance with the ET mode based on the battery voltage 211 and the buck converter voltage 213. An output of the linear regulator 230 may be electrically connected to an output of the buck converter circuit 225. The supply voltage 251 in accordance with the ET mode may be determined based on an output of the linear regulator 230. The APT switch 241 may be opened in the ET mode. The power supply circuit may provide the supply voltage 251 in accordance with the ET mode to a power amplifier. The supply voltage 251 in accordance with the ET mode may be applied to the power amplifier.

In a second example 203, the power supply circuit may operate in an APT mode. APT is a technology that supplies power to a power amplifier by a specified magnitude through a DC-DC converter. In the second example 203, the linear regulator 230 may not operate. In addition to the APT mode, terms such as an AT state, an AT operation, an AT method, a fixed voltage mode, or a fixed power mode, and/or a term having equivalent technical/functional meaning may be used to refer to the APT mode. The boost converter circuit 220 may be configured to output the buck converter voltage 213 based on the battery voltage 211. The buck converter circuit 225 may output a supply voltage 252 V_{cc} in accordance with the APT mode based on the battery voltage 211 and the buck converter voltage 213. In the APT mode, the APT switch 241 may be closed. The APT switch 241 may electrically connect the capacitor 242 to an output of the buck converter circuit 225. The supply voltage 252 in accordance with the APT mode may be affected by the capacitor 242. A DC voltage is generated through the buck converter circuit 225, and the capacitor 242 may be used to maintain a constant voltage. The supply voltage 252 in accordance with the APT mode may have a constant magnitude through the capacitor 242 as exemplified in FIG. 2B to be described later. The power supply circuit may provide the supply voltage 252 in accordance with the APT mode to a power amplifier. The supply voltage 252 in accordance with the APT mode may be applied to the power amplifier.

Referring to FIG. 2B, a graph 260 represents a voltage magnitude 250 and the battery voltage 213 corresponding to a transmission signal. A graph 270 represents the voltage magnitude 250 corresponding to the transmission signal and the supply voltage 252 in accordance with the APT mode. A graph 280 represents the voltage magnitude 250 corresponding to the transmission signal and the supply voltage 251 in accordance with the ET mode. When comparing the graph 260 and the graph 270, since a difference between a supply voltage and a required voltage is small in the APT mode, current consumption when supplying the supply voltage 252 in accordance with the APT mode may be smaller than current consumption when supplying the battery voltage 213 as it is. When comparing the graph 270 and the graph 280, the difference between the supply voltage and the required voltage may be smaller in the ET mode than in the APT mode. However, in the ET mode, the linear regulator 230 may additionally consume power. In terms of power consumption and efficiency, the ET mode may be advantageous over the APT mode, or the APT mode may be advantageous over the ET mode. The electronic device 101 according to embodiments of the present disclosure may control the power supply module to provide the supply voltage 251 in accordance with the ET mode or the supply voltage 252 in accordance with the APT mode to the power amplifier.

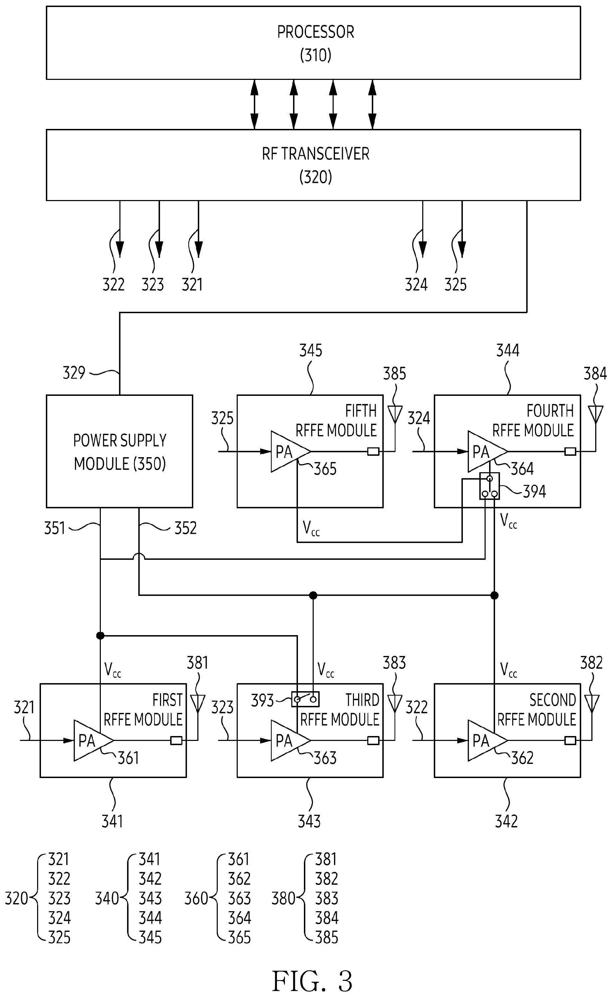

FIG. 3 represents an example of an electronic device (e.g., the electronic device 101 of FIG. 1) including a power supply module.

Referring to FIG. 3, the electronic device 101 may include a processor 310, an RF transceiver 320, RFFE modules 340, a power supply module 350, and antennas 380. The electronic device 101 may include the processor 310. The processor 310 may include at least one of, for example, an application processor (AP) (e.g., the main processor 121 of FIG. 1) or a communication processor (CP) (e.g., the auxiliary processor 123 of FIG. 1). For example, the processor 310 may include the AP and the CP. For example, the processor may include the AP. For example, the processor 310 may include the CP. The processor 310 may control the RF transceiver 320 through a control interface. The processor 310 may control the RF transceiver 320 to transmit a signal through an antenna (e.g., at least one of the antennas 380). The processor 310 may control the RF transceiver 320 to receive a signal.

The electronic device 101 may include the RF transceiver 320. For example, the RF transceiver 320 may be implemented as a single chip (e.g., an RFIC chip) or as a portion of a single package. The RF transceiver 320 may include a digital to analog converter (DAC) for converting a digital signal into an analog signal. The RF transceiver 320 may include a mixer and an oscillator (e.g., a local oscillator (LO)) for up-conversion. The RF transceiver 320 may convert a baseband signal generated by the processor 310 into an RF signal. The RF transceiver 320 may provide an RF signal to an RFFE module (e.g., at least one of the RFFE modules 340). The RF transceiver 320 may include an analog to digital converter (ADC) for converting an analog signal into a digital signal. The RF transceiver 320 may include a mixer and an oscillator for down-conversion. The RF transceiver 320 may convert an RF signal received from an antenna (e.g., at least one of the antennas 380) into a baseband signal to be processed by the processor 310. The RF transceiver 320 may include one or more transmission ports. The RF transceiver 320 may include one or more reception ports. According to an embodiment, the RF transceiver 320 may control at least a portion of the RFFE modules 340 and/or the power supply module 350 through a mobile industry processor interface (MIPI).

The electronic device 101 may include the RFFE modules 340 to support various frequency bands. For example, the electronic device 101 may include a first RFFE module 341, a second RFFE module 342, a third RFFE module 343, a fourth RFFE module 344, and/or a fifth RFFE module 345. Each RFFE module may include a power amplifier (PA). For example, the first RFFE module 341 may include a first PA 361. The second RFFE module 342 may include a second PA 362. The third RFFE module 343 may include a third PA 363. The fourth RFFE module 344 may include a fourth PA 364. The fifth RFFE module 345 may include a fifth PA 365. Each RFFE module may be connected to an antenna for signal transmission. For example, the first RFFE module 341 may be connected to a first antenna 381. The second RFFE module 342 may be connected to a second antenna 382. The third RFFE module 343 may be connected to a third antenna 383. The fourth RFFE module 344 may be connected to a fourth antenna 384. The fifth RFFE module 345 may be connected to a fifth antenna 385. In FIG. 3, an RFFE module including a power amplifier for a transmission path is exemplified, but embodiments of the present disclosure are not limited thereto. For example, the RFFE module may use not only a PAMid including a transmission path, but also an LPAMid further including a component for a reception path (e.g., low noise amplifier (LNA)), as an example of an RFFE module. A module including a power amplifier to which a power in accordance with the ET mode (e.g., a supply voltage 251) or a power in accordance with the APT mode (e.g., a supply voltage 252) is supplied may be understood as an RFFE module of the electronic device 101 according to an embodiment of the present disclosure. In addition, for example, the RFFE module may be understood, in accordance with an implementation, as including not only a single module but also a power amplifier and a FEMid.

The electronic device 101 may include the power supply module 350. The power supply module 350 may be controlled by the processor 120 and/or the RF transceiver 320. The power supply module 350 may be configured to supply power to a plurality of RFFE modules (e.g., the RFFE modules 340). The power supply module 350 may supply a plurality of powers for the plurality of RFFE modules. The power supply module 350 may supply power to each RFFE module of the plurality of RFFE modules. For example, the power supply module 350 may be in a form in which a plurality of modulators are implemented as one module (or IC). Supplying power to an RFFE module may represent that a supply voltage is applied for a PA of the RFFE module. The power supply module 350 may output a plurality of supply voltages for the plurality of RFFE modules. For example, the power supply module 350 may output a first supply voltage 351 and a second supply voltage 352. For example, the first supply voltage 351 may be provided to the first RFFE module 341, the third RFFE module 343, and the fourth RFFE module 344. For example, the second supply voltage 351 may be provided to the second RFFE module 342, the third RFFE module 343, and the fourth RFFE module 344.

The first RFFE module 341 may obtain a first transmission signal 321 from the RF transceiver 320. The first RFFE module 341 may amplify the first transmission signal 321 through the first PA 361. The first supply voltage 351 may be applied to the first PA 361 for an operation of the first PA 361. The first transmission signal 321 amplified through the first PA 361 may be transmitted through the first antenna 381.

The second RFFE module 342 may obtain a second transmission signal 322 from the RF transceiver 320. The second RFFE module 342 may amplify the second transmission signal 321 through the second PA 362. The second supply voltage 352 may be applied to the second PA 362 for an operation of the second PA 362. The second transmission signal 322 amplified through the second PA 362 may be transmitted through the second antenna 382.

The third RFFE module 343 may obtain a third transmission signal 323 from the RF transceiver 320. The third RFFE module 343 may amplify the third transmission signal 323 through the third PA 363. For example, the first supply voltage 351 may be applied to the third PA 363 for an operation of the third PA 363. For example, the third RFFE module 343 may be used for satellite communication. For a high transmission power of the satellite communication, the electronic device 101 may apply both the first supply voltage 351 and the second supply voltage 352 to the third PA 363. For example, the electronic device 101 may operate the third PA 363 by electrically connecting, through a switch 393, a wiring for the second supply voltage 352 to a wiring for the first supply voltage 351. The third transmission signal 323 amplified through the third PA 363 may be transmitted through the third antenna 383.

The fourth RFFE module 344 may obtain a fourth transmission signal 324 from the RF transceiver 320. The fourth RFFE module 342 may amplify the fourth transmission signal 3214 through the fourth PA 364. The first supply voltage 351 or the second supply voltage 352 may be applied to the fourth PA 364 for an operation of the fourth PA 364. For example, the fourth RFFE module 344 may include a switch 394. The switch 394 may be configured to electrically connect one of the wiring for the first supply voltage 351 or the wiring for the second supply voltage 352 to the fourth PA 364, selectively. The switch 394 may operate in accordance with control of the processor 310 or the RF transceiver 320. In accordance with an operation of the switch 394, the first supply voltage 351 may be applied to the fourth PA 364 or the second supply voltage 352 may be applied to the fourth PA 364. The fourth transmission signal 324 amplified through the fourth PA 364 may be transmitted through the fourth antenna 384.

The fifth RFFE module 345 may obtain a fifth transmission signal 325 from the RF transceiver 320. The fifth RFFE module 343 may amplify the fifth transmission signal 321 through the fifth PA 365. The first supply voltage 351 or the second supply voltage 352 may be applied to the fifth PA 365 for an operation of the fifth PA 365. The processor 310 may apply the first supply voltage 351 to the fourth PA 364 or apply the second supply voltage 352 to the fourth PA 364 by controlling the switch 394. For example, a wiring for supplying power to the fifth PA 365 may be connected to the switch 394 of the fourth RFFE module 344. The switch 394 may be configured to electrically connect one of the wiring for the first supply voltage 351 or the wiring for the second supply voltage 352 to the fifth PA 365, selectively. The switch 394 may operate in accordance with control of the processor 310 or the RF transceiver 320. In accordance with an operation of the switch 394, the first supply voltage 351 may be applied to the fifth PA 365 or the second supply voltage 352 may be applied to the fifth PA 365.

According to an embodiment, a power (or voltage/current) of the power supply module 350 may be supplied based on the ET mode or the APT mode. The power supply module 350 may obtain information on an envelope waveform (e.g., an envelope waveform signal 329) from the RF transceiver 320 to output a supply voltage in accordance with the ET mode. The processor 310 may control the RF transceiver 320 to provide the envelope waveform signal 329 to the power supply module 350. The envelope waveform signal 329 may be associated with an input signal of a power amplifier (PA) to which the supply voltage in accordance with the ET mode is applied. For description of the ET mode and the APT mode, FIGS. 2A to 2B may be referenced. The power supply module 350 of the electronic device 101 may include a plurality of power supply circuits for the plurality of supply voltages. Here, each power supply circuit of the plurality of power supply circuits may be referred to as a core of the power supply module 350, a power supply block, a power circuit, a power block, a buck-boost circuit, an operating power supply circuit, a DC supply circuit, and/or an equivalent technical term. Each power supply circuit may output a supply voltage (e.g., the first supply voltage 351 or the second supply voltage 352). For example, the power supply module 350 of the electronic device 101 may output the first supply voltage 351 based on the ET mode or the first supply voltage 351 based on the APT mode. For example, the power supply module 350 of the electronic device 101 may output the second supply voltage 352 based on the ET mode or the second supply voltage 352 based on the APT mode.

If each power supply circuit of the power supply module 350 supports the ET mode, each power supply circuit may include a linear regulator. For example, each power supply circuit of the power supply module 350 may be the power supply circuit of the first example 201 of FIG. 2A. The power supply circuit capable of supporting the ET mode may support the APT mode in accordance with switching from the first example 201 to the second example 203. As an example, due to a technical limitation, ET may not be supported in an approximately 100 MHz bandwidth (e.g., a bandwidth of NR in EUTRA-NR (EN) - dual connectivity (DC)). In the example, the linear regulator of the power supply circuit operating in the APT mode becomes unnecessary and causes a waste of a mounting area. If each power supply circuit of the power supply module 350 supports only the APT mode, each power supply circuit may not include the linear regulator. For example, each power supply circuit of the power supply module 350 may be the power supply circuit of the second example 203 of FIG. 2A. In this case, although current consumption may be reduced based on the ET mode, an excessive current may be consumed due to an operation of the APT mode. In order to reduce current consumption and improve mounting area efficiency based on the above-described problems, a structure and operations of the power supply module 350 for providing a supply voltage in accordance with the ET mode and a supply voltage in accordance with the APT mode are described in the present disclosure.

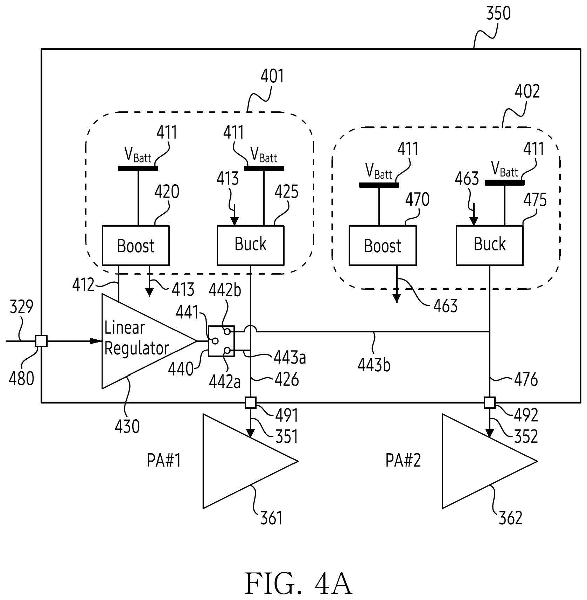

FIGS. 4A to 4B represent examples of a power supply module (e.g., the power supply module 350 of FIG. 3) including a switching circuit. The power supply module 350 according to embodiments of the present disclosure may include a plurality of power supply circuits. In the present disclosure, a power supply circuit is an example for representing a unit for an output, and does not distinguish a physical region in the power supply module 350 or limit a structure of a circuit. In FIG. 4A, an example in which the power supply module 350 of FIG. 3 supplies a first supply voltage 351 to a first PA 361 of a first RFFE module 341 and a second supply voltage 352 to a second PA 362 of a second RFFE module 342 is described.

Referring to FIG. 4A, the power supply module 350 may include a first power supply circuit 401, a second power supply circuit 402, a linear regulator 430, and a switching circuit 440. The first power supply circuit 401 may include a first boost converter circuit 420 and a first buck converter circuit 425. The first boost converter circuit 420 may output a regulator voltage 412 as a boosted voltage to be used as a power of the linear regulator 430. The first boost converter circuit 420 may output a first buck converter voltage 413 as a boosted voltage to be used as a power of the first buck converter circuit 425. The first buck converter voltage 413 may be inputted to the first buck converter circuit 425. The first boost converter circuit 420 may output the regulator voltage 412 and the first buck converter voltage 413 based on a battery voltage 411. For example, the first boost converter circuit 420, as a DC-DC converter, may output the regulator voltage 412 and the first buck converter voltage 413 by boosting the battery voltage 411. The regulator voltage 412 may be supplied to the linear regulator 430. The first buck converter voltage 413 may be supplied to the first buck converter circuit 425. The second power supply circuit 402 may include a second boost converter circuit 470 and a second buck converter circuit 475. The second boost converter circuit 470 may output a second buck converter voltage 463 as a boosted voltage to be used as a power for the second buck converter circuit 475 based on the battery voltage 411. For example, the second boost converter circuit 470, as a DC-DC converter, may output the second buck converter voltage 463, which is an input voltage to the second buck converter circuit 475, by boosting the battery voltage 411. The second buck converter voltage 463 may be supplied to the second buck converter circuit 475.

In an embodiment, the power supply module 350 may include a plurality of power supply ports to supply a plurality of powers. For example, the power supply module 350 may include a first power supply port 491 and a second power supply port 492. The first power supply port 491 may be configured to output the first supply voltage 351. The first supply voltage 351 may be applied to the first PA 361. The second power supply port 492 may be configured to output the second supply voltage 352. The second supply voltage 352 may be applied to the second PA 362.

The linear regulator 430 may operate based on the regulator voltage 412 of the first boost converter circuit 420. The linear regulator 430 may be configured to amplify an envelope waveform signal 329. The linear regulator 430 may amplify the envelope waveform signal 329 based on the regulator voltage 412. An output of the linear regulator 430 in accordance with the amplification may be connected to the switching circuit 440. The switching circuit 440 may be configured to selectively connect the output of the linear regulator 430 to the first power supply circuit 401 or the second power supply circuit 402. For example, the switching circuit 440 may selectively connect the output of the linear regulator 430 to an output 426 of the first power supply circuit 401 or an output 476 of the second power supply circuit 402. For example, while the output of the linear regulator 430 is connected to the first power supply circuit 401, the output of the linear regulator 430 may not be connected to the second power supply circuit 402. For example, while the output of the linear regulator 430 is connected to the second power supply circuit 402, the output of the linear regulator 430 may not be connected to the first power supply circuit 401. As an example, the switching circuit 440 may be a single pole double throw (SPDT). A pole 441 of the switching circuit 440 may be electrically connected to a first throw 442a or a second throw 442b. The pole 441 may be electrically connected to the output of the linear regulator 430. The first throw 442a may be electrically connected to the output 426 of the first power supply circuit 401 through a first supply line 443a. The second throw 442b may be electrically connected to the output 476 of the second power supply circuit 402 through a second supply line 443b.

As the output of the linear regulator 430 is connected to only one power supply circuit (e.g., the first power supply circuit 401 or the second power supply circuit 402) among two power supply circuits through the switching circuit 440, a power in accordance with an ET mode may be selectively supplied to the first PA 361 or the second PA 362. Only one of the first supply voltage 351 and the second supply voltage 352 may be generated based on the ET mode. For example, while a supply voltage in accordance with the ET mode is applied to the second PA 362, the first PA 361 may be disabled or a supply voltage in accordance with an APT mode may be applied. For example, while the supply voltage in accordance with the ET mode is applied to the first PA 361, the second PA 362 may be disabled or the supply voltage in accordance with the APT mode may be applied.

According to an embodiment, in a first state, the switching circuit 440 may connect the output of the linear regulator 430 to the first power supply circuit 401. In the first state, the first power supply circuit 401 may generate the first supply voltage 351 in accordance with the ET mode based on the linear regulator 430. The ET mode may be used to reduce efficiency degradation due to high PAPR. For example, in the ET mode, the first power supply circuit 401 may generate the first supply voltage 351 as a bias voltage of the first PA 361 based on tracking an amplitude of an RF signal related to the first PA 361. The bias voltage may be determined based on an envelope (e.g., an instantaneous output voltage) of the RF signal. In the first state, the second power supply circuit 402 may generate the second supply voltage 352 in accordance with the APT mode without the linear regulator 430. The APT mode may be used to reduce unnecessary power consumption by a power amplifier (e.g., the second PA 362). For example, in the APT mode, the second power supply circuit 402 may generate the second supply voltage 352 corresponding to an average output voltage of the second PA 362. Although not illustrated in FIG. 4A, in the first state, the second power supply circuit 402 may be electrically connected to an external passive element (e.g., a capacitor 242) through an APT switch (e.g., an APT switch 241) in order to generate the second supply voltage 352 in accordance with the APT mode. According to an embodiment, in the first state, the power supply module 350 may be configured to provide the second supply voltage 351 to the second PA 362 based on the APT mode using the second power supply circuit 402, while providing the first supply voltage 351 to the first PA 361 based on the ET mode using the first power supply circuit 401 and the linear regulator 430.

According to an embodiment, in a second state, the switching circuit 440 may connect the output of the linear regulator 430 to the second power supply circuit 402. In the second state, the second power supply circuit 402 may generate the second supply voltage 352 in accordance with the ET mode based on the linear regulator 430. At this time, the linear regulator 430 may receive the regulator voltage 412 from the first boost converter circuit 420 of the first power supply circuit 401. In the second state, the first power supply circuit 401 may generate the first supply voltage 351 in accordance with the APT mode. Although not illustrated in FIG. 4A, in the second state, the first power supply circuit 401 may be electrically connected to an external passive element (e.g., the capacitor 242) through an APT switch (e.g., the APT switch 241) to generate the first supply voltage 351 in accordance with the APT mode. According to an embodiment, in the second state, the power supply module 350 may be configured to provide the second supply voltage 351 to the second PA 362 based on the ET mode using the second power supply circuit 402 and the linear regulator 430, while providing the first supply voltage 351 to the first PA 361 based on the APT mode using the first power supply circuit 401.

The power supply module 350 may include an envelope input port 480 for the envelope waveform signal 329. Since the power supply module 350 includes one linear regulator 430 for two power supply circuits (e.g., the first power supply circuit 401 and the second power supply circuit 402), a wiring (hereinafter, a control line) for the envelope input signal 329 may be disposed between the power supply module 350 and the RF transceiver 320. According to an embodiment, the envelope waveform signal 329 may vary in accordance with whether the switching circuit 440 is in the first state or the second state. For example, in the first state, through the envelope input port 480, a first envelope waveform signal may be provided from the RF transceiver 320 to the power supply module 350. The first envelope waveform signal may be associated with a transmission signal inputted to the first PA 361 so that a voltage in accordance with the ET mode is supplied to the first PA 361. In the second state, through the envelope input port 480, a second envelope waveform signal may be provided from the RF transceiver 320 to the power supply module 350. The second envelope waveform signal may be associated with a transmission signal inputted to the second PA 362 so that a voltage in accordance with the ET mode is supplied to the second PA 362.

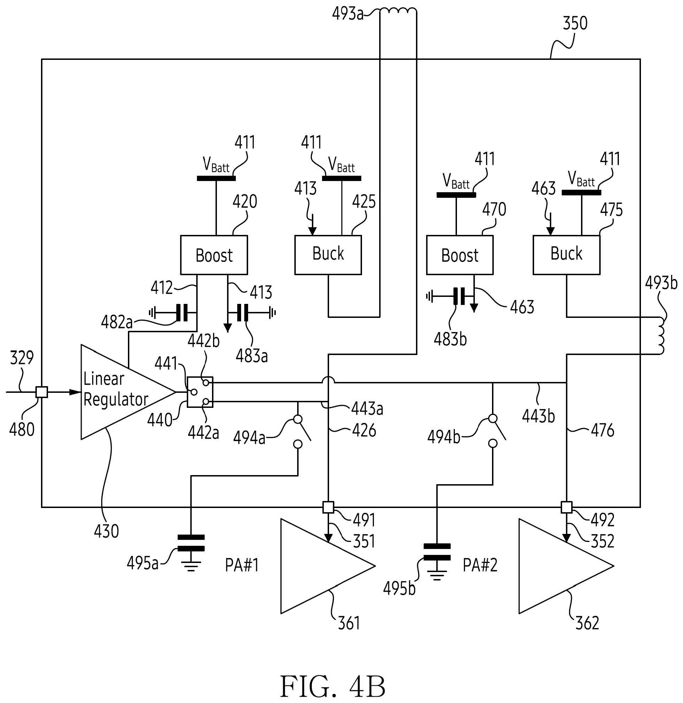

Referring to FIG. 4B, an electronic device 101 may include various passive elements in addition to the circuit illustrated in FIG. 4A, for an operation of a power supply circuit. According to an embodiment, the electronic device 101 may include inductors. For example, the electronic device 101 may include a first inductor 493a. The first inductor 493a may be connected to the first buck converter circuit 425. An output of the first buck converter circuit 425 may be provided to the first power supply port 491 through the first inductor 493a. For example, the electronic device 101 may include a second inductor 493b. The second inductor 493b may be connected to the second buck converter circuit 475. An output of the second buck converter circuit 475 may be provided to the second power supply port 492 through the second inductor 493b. According to an embodiment, the electronic device 101 may include a capacitor 482a, a capacitor 483a, and a capacitor 483b. For example, the capacitor 482a may be connected to an output of the first boost converter circuit 420 supplying the regulator voltage 412. For example, the capacitor 483a may be connected to an output of the first boost converter circuit 420 supplying the first buck converter voltage 413. For example, the capacitor 483b may be connected to an output of the second boost converter circuit 470 supplying the second buck converter voltage 463.

According to an embodiment, the electronic device 101 may include switches and passive elements as a component for the APT mode. For example, the electronic device 101 may include a first APT switch 494a and a first capacitor 495a. The first APT switch 494a may be connected to the output 426 through the first supply line 443a. In a case that the first boost circuit 420 and the first buck converter circuit 425 operate in the APT mode, the first APT switch 494a may electrically connect the first capacitor 495a to the output 426. For example, the first APT switch 494a may be in a closed state. For example, the electronic device 101 may include a second APT switch 494b and a second capacitor 495b. The second APT switch 494b may be electrically connected to the output 476 through the second supply line 443b. In a case that the second boost circuit 470 and the second buck converter circuit 475 operate in the APT mode, the second APT switch 494b may electrically connect the second capacitor 495b to the output 476. For example, the second APT switch 494b may be in a closed state.

In FIGS. 4A to 4B, an example of supplying powers to the first power amplifier 361 and the second power amplifier 362 has been described, but embodiments of the present disclosure are not limited thereto. As illustrated in FIG. 3, the power supply module 350 may be configured to supply power not only to two RFFE modules (e.g., the first RFFE module 341 and the second RFFE module 342), but also to other RFFE modules (e.g., the third RFFE module 343, the fourth RFFE module 344, and the fifth RFFE module 345).

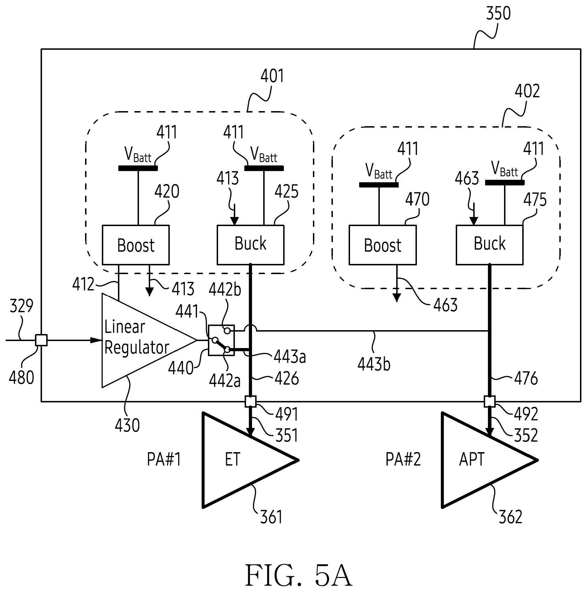

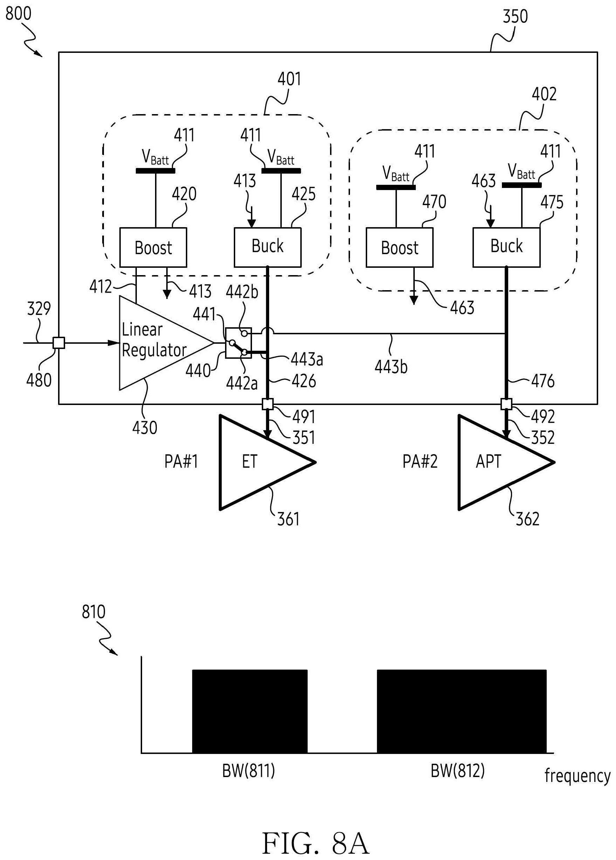

Although switches and passive elements required to describe detailed operations of each circuit are illustrated in FIG. 4B, the circuit illustrated in FIG. 4B is merely an example and should not be interpreted as limiting other embodiments of the present disclosure. Hereinafter, in describing components according to embodiments of the present disclosure through FIGS. 5A to 8B, a circuit for power supply may be illustrated by omitting passive elements and APT switches.

FIGS. 5A to 5B represent examples of control of a switching circuit (e.g., the switching circuit 440 of FIGS. 4A and 4B) of a power supply module (e.g., the power supply module 350 of FIGS. 3, 4A, and 4B). For a description of a structure, a function, and operations of the power supply module 350, the descriptions of FIGS. 3, 4A, and 4B may be referenced. For a description of a structure, a function, and operations of the switching circuit 440, the descriptions of FIGS. 4A and 4B may be referenced.

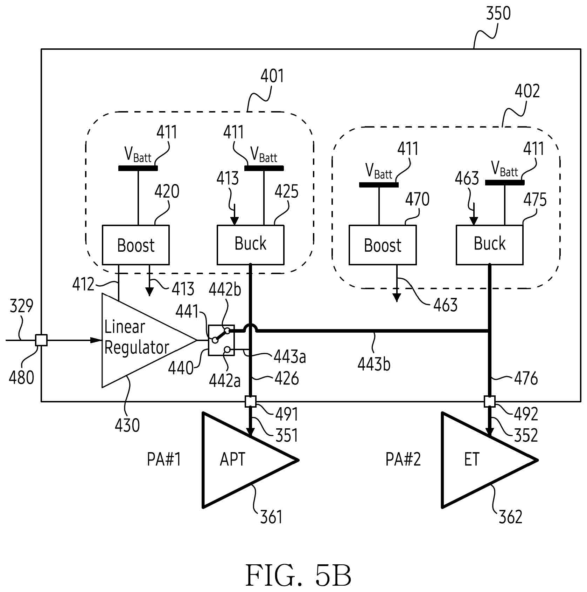

Referring to FIGS. 5A and 5B, the power supply module 350 may include a first power supply circuit 401, a second power supply circuit 402, a linear regulator 430, and the switching circuit 440. The first power supply circuit 401 may include a first boost converter circuit 420 and a first buck converter circuit 425. The first boost converter circuit 420 may output a regulator voltage 412 as a boosted voltage to be used as a power of the linear regulator 430. The first boost converter circuit 420 may output a first buck converter voltage 413 as a boosted voltage to be used as a power of the first buck converter circuit 425. The first buck converter voltage 413 may be inputted to the first buck converter circuit 425. The first boost converter circuit 420 may output the regulator voltage 412 and the first buck converter voltage 413 based on a battery voltage 411. The regulator voltage 412 may be supplied to the linear regulator 430. The first buck converter voltage 413 may be supplied to the first buck converter circuit 425. The second power supply circuit 402 may include a second boost converter circuit 470 and a second buck converter circuit 475. The second boost converter circuit 470 may output a second buck converter voltage 463 as a boosted voltage to be used as a power for the second buck converter circuit 475 based on the battery voltage 411. The second buck converter voltage 463 may be supplied to the second buck converter circuit 475.

The linear regulator 430 may operate based on the regulator voltage 412 of the first boost converter circuit 420. The linear regulator 430 may be configured to amplify an envelope waveform signal 329. The switching circuit 440 may be configured to selectively connect an output of the linear regulator 430 to the first power supply circuit 401 or the second power supply circuit 402. As the output of the linear regulator 430 is connected to only one power supply circuit (e.g., the first power supply circuit 401 or the second power supply circuit 402) among two power supply circuits through the switching circuit 440, only one of a first supply voltage 351 and a second supply voltage 352 may be generated based on an ET mode.

Referring to FIG. 5A, in a case that a voltage in accordance with the ET mode (e.g., the first supply voltage 351) is to be supplied to a first PA 361, an electronic device 101 (e.g., a processor 310) may control the switching circuit 440 so that an output of the linear regulator 430 is connected to an output 426 of the first power supply circuit 401. The switching circuit 440 may operate in a first state. In the first state, the switching circuit 440 may connect the output of the linear regulator 430 to the output 426 of the first power supply circuit 401. The switching circuit 440 may be configured to disconnect the output of the linear regulator 430 and an output 476 of the second power supply circuit 402, while the output of the linear regulator 430 is connected to the output 426 of the first power supply circuit 401. In the first state, the first power supply circuit 401 may generate the first supply voltage 351 in accordance with the ET mode based on the output of the linear regulator 430. In the first state, the second power supply circuit 402 may generate the second supply voltage 352 in accordance with an APT mode through the second boost converter circuit 470 and the second buck converter circuit 475. In the APT mode, an APT switch (e.g., a second APT switch 494b) and at least one passive element (e.g., an external capacitor or a second capacitor 495b) connected through the APT switch may be used to maintain an output voltage of the second buck converter circuit 475 within a certain range without fluctuation. According to an embodiment, in the first state, the power supply module 350 may be configured to provide the second supply voltage 351 to a second PA 362 based on the APT mode using the second power supply circuit 402, while providing the first supply voltage 351 to the first PA 361 based on the ET mode using the first power supply circuit 401 and the linear regulator 430.

Referring to FIG. 5B, in a case that a voltage in accordance with the ET mode (e.g., the second supply voltage 352) is to be supplied to the second PA 361, the electronic device 101 (e.g., the processor 310) may control the switching circuit 440 so that an output of the linear regulator 430 is connected to the output 476 of the second power supply circuit 402. The switching circuit 440 may operate in a second state. In the second state, the switching circuit 440 may connect the output of the linear regulator 430 to the output 476 of the second power supply circuit 402. The switching circuit 440 may be configured to disconnect the output of the linear regulator 430 and the output 426 of the first power supply circuit 401, while the output of the linear regulator 430 is connected to the output 476 of the second power supply circuit 402. In the second state, the first power supply circuit 401 may generate the second supply voltage 352 in accordance with the APT mode through the first boost converter circuit 420 and the first buck converter circuit 425. In the APT mode, an APT switch (e.g., a first APT switch 494a) and at least one passive element (e.g., an external capacitor or the first capacitor 495a) connected through the APT switch may be used to maintain an output voltage of the first buck converter circuit 425 within a certain range without fluctuation. In the second state, the second power supply circuit 402 may generate the second supply voltage 352 in accordance with the ET mode based on the output of the linear regulator 430. According to an embodiment, in the second state, the power supply module 350 may be configured to provide the first supply voltage 351 to the first PA 361 based on the APT mode using the first power supply circuit 401, while providing the second supply voltage 352 to the second PA 362 based on the ET mode using the second power supply circuit 402 and the linear regulator 430.

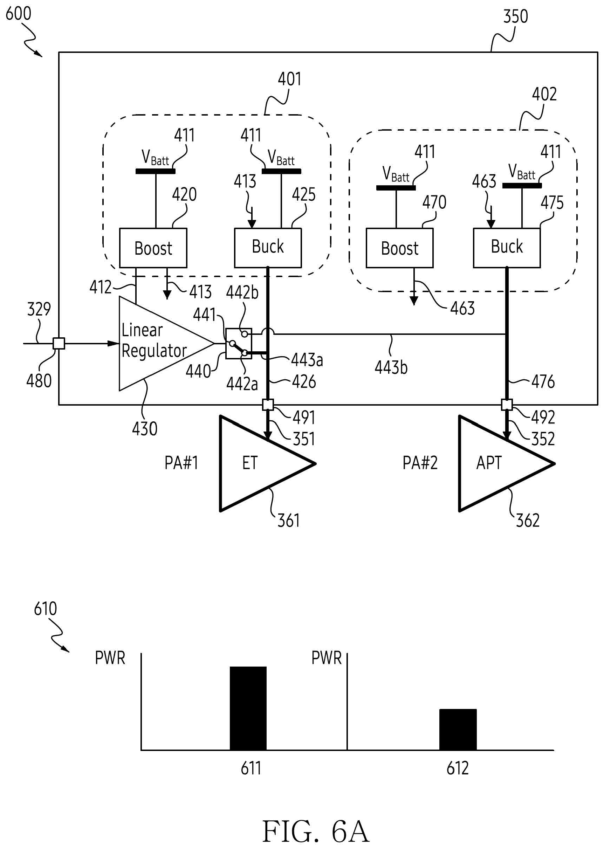

FIGS. 6A to 6B represent examples of control of a switching circuit (e.g., the switching circuit 440 of FIGS. 4A, 4B, 5A, and 5B) of a power supply module (e.g., the power supply module 350 of FIGS. 3, 4A, 4B, 5A, and 5B) in accordance with a transmission power. For a description of a structure, a function, and operations of the power supply module 350, the descriptions of FIGS. 3, 4A, 4B, 5A, and 5B may be referenced. For a description of a structure, a function, and operations of the switching circuit 440, the descriptions of FIGS. 4A, 4B, 5A, and 5B may be referenced.

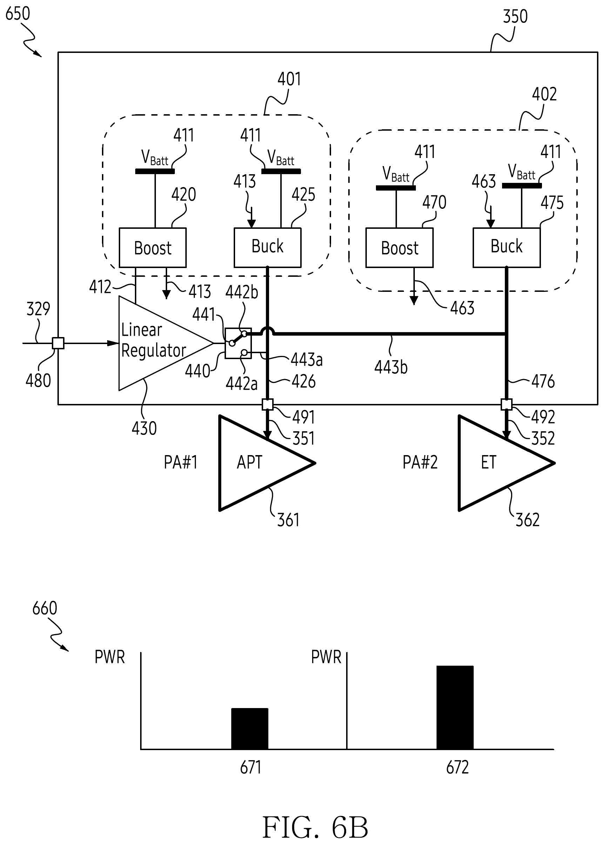

Referring to FIGS. 6A and 6B, the power supply module 350 may include a first power supply circuit 401, a second power supply circuit 402, a linear regulator 430, and the switching circuit 440. The first power supply circuit 401 may include a first boost converter circuit 420 and a first buck converter circuit 425. The first boost converter circuit 420 may output a regulator voltage 412 as a boosted voltage to be used as a power of the linear regulator 430. The first boost converter circuit 420 may output a first buck converter voltage 413 as a boosted voltage to be used as a power of the first buck converter circuit 425. The first buck converter voltage 413 may be inputted to the first buck converter circuit 425. The first boost converter circuit 420 may output the regulator voltage 412 and the first buck converter voltage 413 based on a battery voltage 411. The regulator voltage 412 may be supplied to the linear regulator 430. The first buck converter voltage 413 may be supplied to the first buck converter circuit 425. The second power supply circuit 402 may include a second boost converter circuit 470 and a second buck converter circuit 475. The second boost converter circuit 470 may output a second buck converter voltage 463 as a boosted voltage to be used as a power for the second buck converter circuit 475 based on the battery voltage 411. The second buck converter voltage 463 may be supplied to the second buck converter circuit 475.

The linear regulator 430 may be configured to amplify an envelope waveform signal 329. The switching circuit 440 may be configured to selectively connect an output of the linear regulator 430 to the first power supply circuit 401 or the second power supply circuit 402. As the output of the linear regulator 430 is connected to only one power supply circuit (e.g., the first power supply circuit 401 or the second power supply circuit 402) among two power supply circuits through the switching circuit 440, only one of a first supply voltage 351 and a second supply voltage 352 may be generated based on an ET mode. Which power supply circuit is to generate a voltage in accordance with the ET mode may be determined based on a power of a power amplifier. For example, each power supply circuit may operate based on a power range of the power amplifier. As a transmission signal of the power amplifier has higher power, a supply voltage in accordance with the ET mode is more advantageous as a bias voltage than a supply voltage in accordance with an APT mode. If the supply voltage in accordance with the APT mode is provided to the power amplifier, a peak signal increases as power increases, and thus a magnitude of a bias voltage applied to the power amplifier inevitably increases. Due to the high magnitude of the bias voltage, a situation in which an unnecessarily high voltage is supplied may occur in a partial region of the transmission signal. Therefore, the supply voltage in accordance with the ET mode may be provided for a power amplifier corresponding to a high-power transmission signal among two transmission signals.

The electronic device 101 (e.g., the processor 310) may obtain information corresponding to a first power of a first transmission signal. The first transmission signal may be a signal transmitted through a first PA 361 and a first antenna 381. The electronic device 101 may obtain information corresponding to a second power of a second transmission signal. The second transmission signal may be a signal transmitted through a second PA 362 and a second antenna 382. The electronic device 101 may generate a supply voltage corresponding to a greater power between the first power and the second power based on the ET mode, by comparing the first power and the second power.

Referring to FIG. 6A, in an example 600 of the power supply module 350, the switching circuit 440 may operate in a first state (e.g., the first state of FIGS. 4A, 4B, 5A, and 5B). A graph 610 represents power of each transmission signal. For example, a first power 611 of the first transmission signal in accordance with the first PA 361 may be greater than a second power 612 of the second transmission signal in accordance with the second PA 362. The electronic device 101 (e.g., the processor 310) may confirm that the first power 611 is greater than the second power 612. Based on confirming that the first power 611 is greater than the second power 612, the electronic device 101 (e.g., the processor 310) may control the switching circuit 440 to operate in the first state. The electronic device 101 (e.g., the processor 310) may control the switching circuit 440 so that an output of the linear regulator 430 is connected to an output 426 of the first power supply circuit 401. In the first state, the first power supply circuit 401 may generate the first supply voltage 351 in accordance with the ET mode based on the output of the linear regulator 430. In the first state, the second power supply circuit 402 may generate the second supply voltage 352 in accordance with the APT mode through the second boost converter circuit 470 and the second buck converter circuit 475. In the APT mode, an APT switch (e.g., a second APT switch 494b) and at least one passive element (e.g., an external capacitor or a second capacitor 495b) connected through the APT switch may be used to maintain an output voltage of the second buck converter circuit 475 within a certain range without fluctuation.

Referring to FIG. 6B, in an example 650 of the power supply module 350, the switching circuit 440 may operate in a second state (e.g., the second state of FIGS. 4A, 4B, 5A, and 5B). A graph 660 represents power of each transmission signal. For example, a first power 611 of the first transmission signal in accordance with the first PA 361 may be less than a second power 612 of the second transmission signal in accordance with the second PA 362. The electronic device 101 (e.g., the processor 310) may confirm that the second power 672 is greater than the first power 671. Based on confirming that the second power 612 is greater than the first power 611, the electronic device 101 (e.g., the processor 310) may control the switching circuit 440 to operate in the second state. The electronic device 101 (e.g., the processor 310) may control the switching circuit 440 such that an output of the linear regulator 430 is connected to an output 476 of the second power supply circuit 402. In the second state, the second power supply circuit 402 may generate the second supply voltage 352 in accordance with the ET mode based on the output of the linear regulator 430. In the second state, the first power supply circuit 401 may generate the second supply voltage 352 in accordance with the APT mode through the first boost converter circuit 420 and the first buck converter circuit 425. In the APT mode, an APT switch (e.g., a first APT switch 494a) and at least one passive element (e.g., an external capacitor or the first capacitor 495a) connected through the APT switch may be used to maintain an output voltage of the first buck converter circuit 425 within a certain range without fluctuation.

In FIGS. 6A and 6B, an example in which a voltage in accordance with the ET mode is supplied to a power amplifier and a voltage in accordance with the APT mode is supplied to another power amplifier by comparing powers of transmission signals of two power amplifiers has been described.

Meanwhile, unlike those described in FIGS. 6A to 6B, instead of simply comparing two powers, by confirming whether power of each transmission signal is greater than a power threshold, it may be distinguished whether the power is high power or low power (or medium power). For example, the electronic device 101 (e.g., the processor 310) may confirm that the first power of the first transmission signal is greater than the power threshold. The electronic device 101 may confirm that the second power of the second transmission signal is less than or equal to the power threshold. The electronic device 101 may output the first supply voltage 351 in accordance with the ET mode as a bias voltage of a power amplifier (e.g., the first PA 361) corresponding to the first power greater than the power threshold. The electronic device 101 may output the second supply voltage 352 in accordance with the APT mode as a bias voltage of a power amplifier (e.g., the second PA 362) corresponding to the second power less than or equal to the power threshold. If both of the two powers are greater than the power threshold or both of the two powers are less than the power threshold, the electronic device 101 may determine a power to be supplied in accordance with the APT mode and a power to be supplied in accordance with the ET mode through comparison of the two powers, as described in FIGS. 6A to 6B.

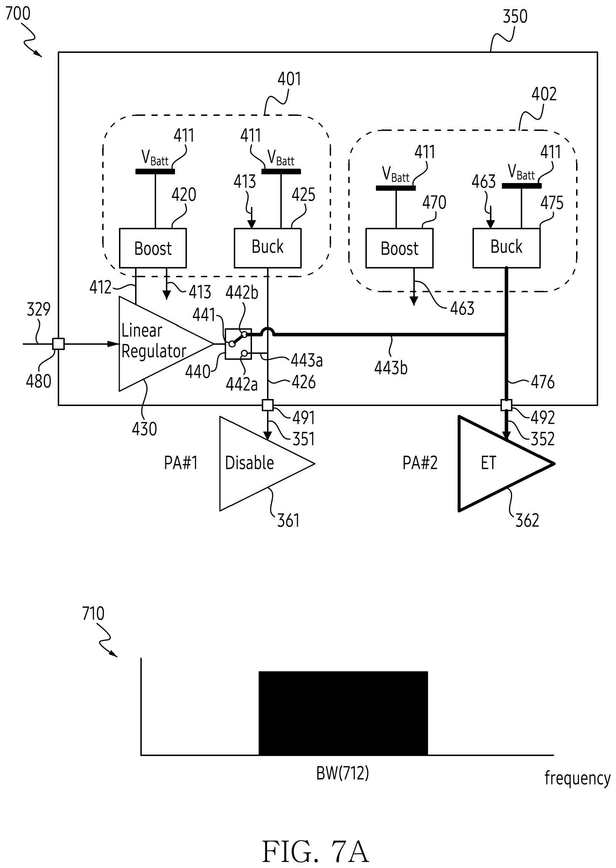

FIGS. 7A to 7B represent examples of control of a switching circuit (e.g., the switching circuit 440 of FIGS. 4A, 4B, 5A, and 5B) of a power supply module (e.g., the power supply module 350 of FIGS. 3, 4A, 4B, 5A, and 5B) in accordance with a bandwidth. For a description of a structure, a function, and operations of the power supply module 350, the descriptions of FIGS. 3, 4A, 4B, 5A, and 5B may be referenced. For a description of a structure, a function, and operations of the switching circuit 440, the descriptions of FIGS. 4A, 4B, 5A, and 5B may be referenced.

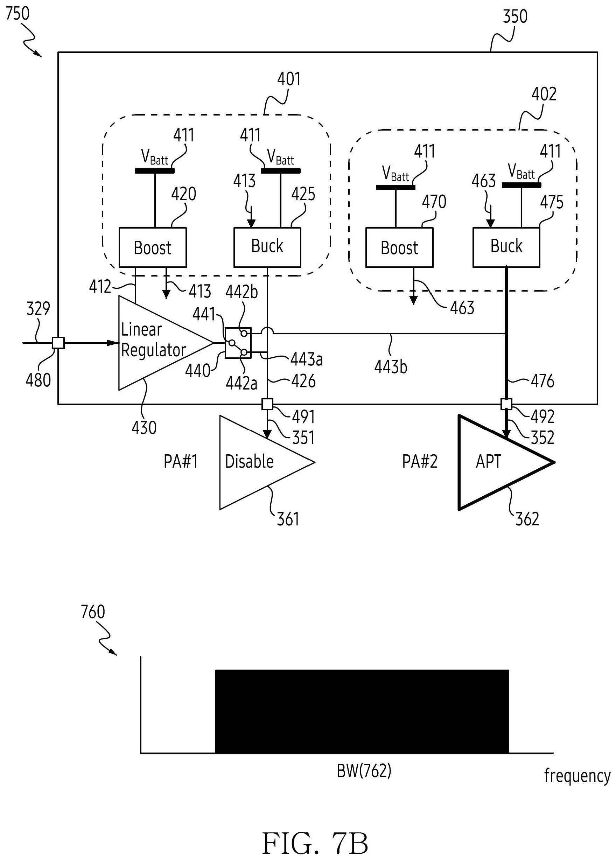

Referring to FIGS. 7A and 7B, the power supply module 350 may include a first power supply circuit 401, a second power supply circuit 402, a linear regulator 430, and the switching circuit 440. The first power supply circuit 401 may include a first boost converter circuit 420 and a first buck converter circuit 425. The first boost converter circuit 420 may output a regulator voltage 412 as a boosted voltage to be used as a power of the linear regulator 430. The first boost converter circuit 420 may output a first buck converter voltage 413 as a boosted voltage to be used as a power of the first buck converter circuit 425. The first buck converter voltage 413 may be inputted to the first buck converter circuit 425. The first boost converter circuit 420 may output the regulator voltage 412 and the first buck converter voltage 413 based on a battery voltage 411. The regulator voltage 412 may be supplied to the linear regulator 430. The first buck converter voltage 413 may be supplied to the first buck converter circuit 425. The second power supply circuit 402 may include a second boost converter circuit 470 and a second buck converter circuit 475. The second boost converter circuit 470 may output a second buck converter voltage 463 as a boosted voltage to be used as a power for the second buck converter circuit 475 based on the battery voltage 411. The second buck converter voltage 463 may be supplied to the second buck converter circuit 475.

The linear regulator 430 may operate based on the first boost converter circuit 420 of the first power supply circuit 401. For example, the linear regulator 430 may be configured to amplify an envelope waveform signal 329 based on the regulator voltage 412 of the first boost converter circuit 420. Even if the linear regulator 430 operates through the first boost converter circuit 420, an output of the linear regulator 430 may be connected to an output 426 of the first power supply circuit 401 or an output 476 of the second power supply circuit 402. The switching circuit 440 may be configured to selectively connect the output of the linear regulator 430 to the first power supply circuit 401 or the second power supply circuit 402. Therefore, even if a first PA 361 is disabled, a second PA 362 may use a supply voltage in accordance with an APT mode or a supply voltage in accordance with an ET mode as a bias voltage. Meanwhile, due to a design constraint, a linear regulator (e.g., the linear regulator 430) is not easy to amplify a signal having a bandwidth greater than or equal to a certain bandwidth (e.g., approximately 60 MHz). Since a specific frequency band (e.g., a frequency band of 5G NR) supports a bandwidth (e.g., a bandwidth of approximately 100 MHz) greater than 60 MHz, a type of power to be supplied to a power amplifier for a transmission signal may be determined in accordance with a bandwidth of the transmission signal. For example, in a case that a bandwidth of a second transmission signal of the second PA 362 is approximately 100 MHz, a second supply voltage 352 is difficult to be generated based on the ET mode, and thus should be generated based on the APT mode. For another example, in a case that the bandwidth of the second transmission signal of the second PA 362 is approximately 20 MHz, the linear regulator 430 is available while the first PA 361 is disabled, and thus the second supply voltage 352 may be generated based on the ET mode.

Referring to FIG. 7A, in an example 700 of the power supply module 350, the switching circuit 440 may operate in a second state (e.g., the second state of FIGS. 4A, 4B, 5A, and 5B). The first PA 361 may be disabled. A graph 710 represents a bandwidth 712 of a transmission signal of the second PA 362. An electronic device 101 (e.g., a processor 310) may confirm that the bandwidth 712 is less than a bandwidth threshold. While the first PA 361 is disabled, based on confirming that the bandwidth 712 is less than the bandwidth threshold, the electronic device 101 (e.g., the processor 310) may control the switching circuit 440 to operate in the second state. The electronic device 101 (e.g., the processor 310) may control the switching circuit 440 so that an output of the linear regulator 430 is connected to the output 476 of the second power supply circuit 402. In the second state, the second power supply circuit 402 may generate the second supply voltage 352 in accordance with the ET mode based on the output of the linear regulator 430. In the second state, even if an output power of the first buck converter circuit 425 is supplied to the first PA 361 in accordance with the APT mode, the disabled first PA 361 may not consume a current. In addition, if a buck converter circuit is disabled even when the first buck converter voltage 413 exists, a current is not consumed, and thus efficiency degradation due to power supply may not occur.

Referring to FIG. 7B, in an example 750 of the power supply module 350, the switching circuit 440 may operate in a first state (e.g., the first state of FIGS. 4A, 4B, 5A, and 5B). The first PA 361 may be disabled. A graph 760 represents a bandwidth 762 of a transmission signal of the second PA 362. The electronic device 101 (e.g., the processor 310) may confirm that the bandwidth 762 is greater than a bandwidth threshold. While the first PA 361 is disabled, based on confirming that the bandwidth 762 is greater than the bandwidth threshold, the electronic device 101 (e.g., the processor 310) may control the switching circuit 440 to operate in the first state. The electronic device 101 (e.g., the processor 310) may control the switching circuit 440 so that an output of the linear regulator 430 is connected to the output 426 of the first power supply circuit 401. In the second state, the second power supply circuit 402 may generate the second supply voltage 352 in accordance with the APT mode. For example, in the second state, the first power supply circuit 401 and/or the linear regulator 430 may be disabled. Therefore, due to the disabled circuit, degradation in efficiency of power supply may be insignificant. For another example, in the second state, even if power is supplied to the first PA 361, the disabled first PA 361 may not consume a current.

FIGS. 8A to 8B represent examples of control of a switching circuit (e.g., the switching circuit 440 of FIGS. 4A, 4B, 5A, and 5B) of a power supply module (e.g., the power supply module 350 of FIGS. 3, 4A, 4B, 5A, and 5B) in accordance with a bandwidth. For a description of a structure, a function, and operations of the power supply module 350, the descriptions of FIGS. 3, 4A, 4B, 5A, and 5B may be referenced. For a description of a structure, a function, and operations of the switching circuit 440, the descriptions of FIGS. 4A, 4B, 5A, and 5B may be referenced.

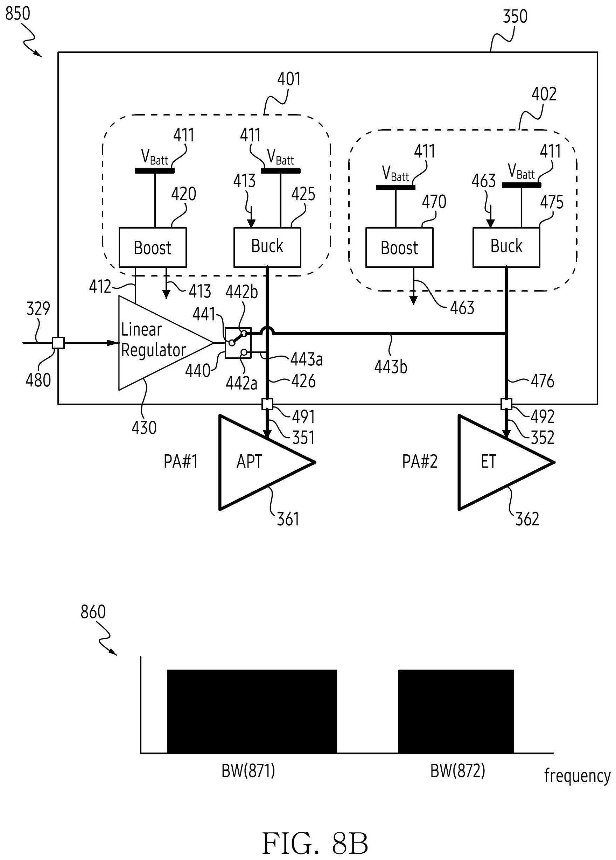

Referring to FIGS. 8A and 8B, the power supply module 350 may include a first power supply circuit 401, a second power supply circuit 402, a linear regulator 430, and the switching circuit 440. The first power supply circuit 401 may include a first boost converter circuit 420 and a first buck converter circuit 425. The first boost converter circuit 420 may output a regulator voltage 412 as a boosted voltage to be used as a power of the linear regulator 430. The first boost converter circuit 420 may output a first buck converter voltage 413 as a boosted voltage to be used as a power of the first buck converter circuit 425. The first buck converter voltage 413 may be inputted to the first buck converter circuit 425. The first boost converter circuit 420 may output the regulator voltage 412 and the first buck converter voltage 413 based on a battery voltage 411. The regulator voltage 412 may be supplied to the linear regulator 430. The first buck converter voltage 413 may be supplied to the first buck converter circuit 425. The second power supply circuit 402 may include a second boost converter circuit 470 and a second buck converter circuit 475. The second boost converter circuit 470 may output a second buck converter voltage 463 as a boosted voltage to be used as a power for the second buck converter circuit 475 based on the battery voltage 411. The second buck converter voltage 463 may be supplied to the second buck converter circuit 475.

The linear regulator 430 may operate based on the first boost converter circuit 420 of the first power supply circuit 401. For example, the linear regulator 430 may be configured to amplify an envelope waveform signal 329 based on the regulator voltage 412 of the first boost converter circuit 420. While a second supply voltage 352 is applied to a second PA 362, a first supply voltage 351 may be applied as a bias voltage of an enabled first PA 361. As an output of the linear regulator 430 is connected to only one power supply circuit (e.g., the first power supply circuit 401 or the second power supply circuit 402) among two power supply circuits through the switching circuit 440, only one of the first supply voltage 351 and the second supply voltage 352 may be generated based on an ET mode. Meanwhile, due to a limitation of a capability of the linear regulator 430, a signal having a bandwidth greater than or equal to a certain bandwidth (e.g., approximately 60 MHz) is not easy to amplify. Therefore, in accordance with a bandwidth of a transmission signal, a power amplifier to which power in accordance with the ET mode is to be supplied may be determined. According to an embodiment, an electronic device 101 (e.g., a processor 310) may confirm a combination of frequency bands to be provided through the power supply module 350. For example, in a dual connectivity (DC) or uplink (UL) carrier aggregation (CA) situation, a combination of frequency bands to be used for transmission may be confirmed through RFFE modules. The electronic device 101 may control the switching circuit 440 based on a first bandwidth of a first frequency band and a second bandwidth of a second frequency band represented by the combination. For example, if the first bandwidth is less than a bandwidth threshold for an operation of the linear regulator 430 and the second bandwidth is greater than or equal to the bandwidth threshold, the electronic device 101 may control the switching circuit 440 so that the switching circuit 440 operates in a first state. For a detailed structure of the power supply module 350, FIG. 8A may be referenced. For another example, if the second bandwidth is less than the bandwidth threshold for the operation of the linear regulator 430, and the first bandwidth is greater than or equal to the bandwidth threshold, the electronic device 101 may control the switching circuit 440 so that the switching circuit 440 operates in a second state. For a detailed structure of the power supply module 350, FIG. 8B may be referenced.

Referring to FIG. 8A, in an example 800 of the power supply module 350, the switching circuit 440 may operate in the first state (e.g., the first state of FIGS. 4A, 4B, 5A, and 5B). A graph 810 represents a first bandwidth 811 of a first transmission signal of the first PA 361 and a second bandwidth 812 of a second transmission signal of the second PA 362. A horizontal axis of the graph 810 represents a frequency domain, and a wider spread along the horizontal axis represents a larger bandwidth. For example, the first bandwidth 811 may be less than a bandwidth threshold (e.g., approximately 60 MHz). The second bandwidth 812 may be greater than the bandwidth threshold (e.g., about 60 MHz). Since envelope tracking (ET) for the second transmission signal is difficult, the electronic device 101 (e.g., the processor 310) may control the switching circuit 440 to operate in the first state. The electronic device 101 (e.g., the processor 310) may control the switching circuit 440 so that an output of the linear regulator 430 is connected to an output 426 of the first power supply circuit 401. In the first state, the first power supply circuit 401 may generate the first supply voltage 351 in accordance with the ET mode based on the output of the linear regulator 430. In the first state, the second power supply circuit 402 may generate the second supply voltage 352 in accordance with an APT mode through the second boost converter circuit 470 and the second buck converter circuit 475. In the APT mode, an APT switch (e.g., a second APT switch 494b) of the second power supply circuit 402 and at least one passive element (e.g., an external capacitor or a second capacitor 495b) connected through the APT switch may be used to maintain an output voltage of the second buck converter circuit 475 within a certain range without fluctuation.

Referring to FIG. 8B, in an example 850 of the power supply module 350, the switching circuit 440 may operate in the second state (e.g., the second state of FIGS. 4A, 4B, 5A, and 5B). A graph 870 represents a first bandwidth 871 of a first transmission signal of the first PA 361 and a second bandwidth 872 of a second transmission signal of the second PA 362. A horizontal axis of the graph 870 represents a frequency domain, and a wider spread along the horizontal axis represents a larger bandwidth. For example, the first bandwidth 871 may be greater than a bandwidth threshold (e.g., approximately 60 MHz). The second bandwidth 872 may be less than the bandwidth threshold (e.g., approximately 60 MHz). Since ET for the first transmission signal is difficult, the electronic device 101 (e.g., the processor 310) may control the switching circuit 440 to operate in the second state. The electronic device 101 (e.g., the processor 310) may control the switching circuit 440 so that an output of the linear regulator 430 is connected to an output 476 of the second power supply circuit 402. In the second state, the first power supply circuit 401 may generate the second supply voltage 352 in accordance with the APT mode through the first boost converter circuit 420 and the first buck converter circuit 425. In the APT mode, an APT switch (e.g., a first APT switch 494a) and at least one passive element (e.g., an external capacitor or the first capacitor 495a) connected through the APT switch may be used to maintain an output voltage of the first buck converter circuit 425 within a certain range without fluctuation. In the second state, the second power supply circuit 402 may generate the second supply voltage 352 in accordance with the ET mode based on the output of the linear regulator 430.

In FIGS. 8A to 8B, a situation in which a bandwidth of a transmission signal is greater than or equal to a bandwidth threshold and a bandwidth of another transmission signal is less than the bandwidth threshold is described, but examples according to the present disclosure are not limited thereto. For example, bandwidths of signals amplified through the power supply module 350 may all be less than the bandwidth threshold. According to an embodiment, the electronic device 101 (e.g., the processor 310) may generate a supply power corresponding to a signal having a larger bandwidth among the signals based on the ET mode. For example, in a case that a first bandwidth of the first transmission signal of the first PA 361 is narrower than a second bandwidth of the second transmission signal of the second PA 362 and the second bandwidth is less than the bandwidth threshold, in the electronic device 101, the electronic device 101 (e.g., the processor 310) may generate the second supply voltage 352 for the second transmission signal based on the ET mode. The electronic device 101 may control the switching circuit 440 to operate in the second state. In the second state, the switching circuit 440 may connect the output of the linear regulator 430 to the second power supply circuit 402. While the second supply voltage 352 for the second transmission signal is supplied, the electronic device 101 may generate the first supply voltage 351 for the first transmission signal based on the APT mode.

For example, the bandwidths of the signals amplified through the power supply module 350 may all be equal to or greater than the bandwidth threshold. Since the linear regulator 430 is difficult to operate for the signal having the bandwidth greater than or equal to the bandwidth threshold, the linear regulator 430 may not operate. According to an embodiment, the electronic device 101 may control the power supply module 350 so that the output of the linear regulator 430 is not connected to any buck converter circuit (e.g., the first buck converter circuit 425 or the second buck converter circuit 475). For example, the electronic device 101 may disable the switching circuit 440, which is an SPDT.

Since the disabled SPDT is in a floating state, the linear regulator 430 may be in a state of not being electrically connected to any buck converter circuit (e.g., the first buck converter circuit 425 or the second buck converter circuit 475).

The power supply module 350 according to embodiments of the present disclosure may provide an RF system for simplifying a mounting area and reducing current consumption by a linear regulator, by flexibly supplying powers (e.g., the first supply voltage 351 and the second supply voltage 352) to a plurality of power amplifiers in accordance with the ET mode and/or the APT mode. The effects that may be obtained from the present disclosure are not limited to those described above, and any other effects not mentioned herein will be clearly understood by those having ordinary knowledge in the art to which the present disclosure belongs, from the following description.

In embodiments, an electronic device 101 is provided. The electronic device 101 may comprise a processor 310, a radio frequency (RF) transceiver 320, a first radio frequency front end (RFFE) module including a first power amplifier 361, a second RFFE module including a second power amplifier 362, and a power supply module 350 including a first power supply circuit 401 for the first power amplifier 361, a second power supply circuit 402 for the second power amplifier 362, a linear regulator 430, and a switching circuit 440 configured to connect an output of the linear regulator 430 to the first power supply circuit 401 or the second power supply circuit 402 selectively. The processor 310 may be configured to, in a first state, control the switching circuit 440 to provide, while providing a first supply voltage 351 to the first power amplifier 361 through the power supply module 350 based on an envelope tracking (ET) mode using the linear regulator 430 and the first power supply circuit 401, a second supply voltage 352 to the second power amplifier 362 through the power supply module 350 based on an average power tracking (APT) mode using the second power supply circuit 402. The processor 310 may be configured to, in a second state, control the switching circuit 440 to provide, while providing the first supply voltage 351 to the first power amplifier 361 through the power supply module 350 based on an APT mode using the first power supply circuit 401, the second supply voltage 352 to the second power amplifier 362 through the power supply module 350 based on an ET mode using the linear regulator 430 and the second power supply circuit 402.

In embodiments, an electronic device 101 is provided. The electronic device 101 may comprise a processor 310, a radio frequency (RF) transceiver 320, a first radio frequency front end (RFFE) module including a first power amplifier 361, a second RFFE module including a second power amplifier 362, and a power supply module 350 including a first power supply circuit 401 for the first power amplifier 361, a second power supply circuit 402 for the second power amplifier 362, a linear regulator 430, and a switching circuit 440 configured to connect an output of the linear regulator 430 to the first power supply circuit 401 or the second power supply circuit 402 selectively. The switching circuit 440 may be controlled, in accordance with the processor 310 or the RF transceiver 320, to, in a first state, provide, while providing a first supply voltage 351 to the first power amplifier 361 through the power supply module 350 based on an envelope tracking (ET) mode using the linear regulator 430 and the first power supply circuit 401, a second supply voltage 352 to the second power amplifier 362 through the power supply module 350 based on an average power tracking (APT) mode using the second power supply circuit 402. The switching circuit 440 may be controlled, in accordance with the processor 310 or the RF transceiver 320, to, in a second state, provide, while providing the first supply voltage 351 to the first power amplifier 361 through the power supply module 350 based on an APT mode using the first power supply circuit 401, the second supply voltage 352 to the second power amplifier 362 through the power supply module 350 based on an ET mode using the linear regulator 430 and the second power supply circuit 402.

According to an embodiment, the first power supply circuit 401 may include a first buck converter circuit 425 and a first boost converter circuit 420 for the first buck converter circuit 425. The second power supply circuit 402 may include a second buck converter circuit 475 and a second boost converter circuit 470 for the second buck converter circuit 475. The first boost converter circuit 420 may be configured to supply a regulator voltage to the linear regulator 430. An output of the linear regulator 430 may be connected, through the switching circuit 440, to the first buck converter circuit 425 of the first power supply circuit 401 or to the second buck converter circuit 475 of the second power supply circuit 402 selectively.

According to an embodiment, the processor 310 may be configured to obtain information corresponding to a first power of the first power amplifier 361. It may be configured to obtain information corresponding to a second power of the second power amplifier 362. The processor 310 may be configured to, in a case that the first power is greater than the second power, control the switching circuit 440 to operate in a first state in which an output of the linear regulator 430 is connected to the first power supply circuit 401. The processor 310 may be configured to, in a case that the first power is not greater than the second power, control the switching circuit 440 to operate in a second state in which an output of the linear regulator 430 is connected to the second power supply circuit 402.

According to an embodiment, the switching circuit 440 may be controlled, in accordance with the processor 310 or the RF transceiver 320, to, in a case that a first power of the first power amplifier is greater than a second power of the second power amplifier, operate in a first state in which an output of the linear regulator 430 is connected to the first power supply circuit 401. The switching circuit 440 may be controlled, in accordance with the processor 310 or the RF transceiver 320, to, in a case that the first power is not greater than the second power, operate in a second state in which an output of the linear regulator 430 is connected to the second power supply circuit 402.

According to an embodiment, the processor 310 may be configured to obtain information corresponding to a first bandwidth of a first signal of the first power amplifier 361, and obtain information corresponding to a second bandwidth of a second signal of the second power amplifier 362. The processor 310 may be configured to, in a case that the first bandwidth is smaller than a bandwidth threshold and the second bandwidth is greater than or equal to the bandwidth threshold, control the switching circuit 440 to operate in a first state in which an output of the linear regulator 430 is connected to the first power supply circuit 401. The processor 310 may be configured to, in a case that the first bandwidth is greater than or equal to the bandwidth threshold and the second bandwidth is smaller than the bandwidth threshold, control the switching circuit 440 to operate in a second state in which an output of the linear regulator 430 is connected to the second power supply circuit 402.

According to an embodiment, the switching circuit 440 may be controlled, in accordance with the processor 310 or the RF transceiver 320, to, in a case that a first bandwidth of a first signal of the first power amplifier is smaller than a bandwidth threshold and a second bandwidth of a second signal of the second power amplifier is greater than or equal to the bandwidth threshold, operate in a first state in which an output of the linear regulator 430 is connected to the first power supply circuit, and in a case that the first bandwidth is greater than or equal to the bandwidth threshold and the second bandwidth is smaller than the bandwidth threshold, operate in a second state in which an output of the linear regulator 430 is connected to the second power supply circuit.

According to an embodiment, the processor 310 may be configured to obtain information corresponding to a second bandwidth of a second signal of the second power amplifier 362. The processor 310 may be configured to, in a case that the second bandwidth of the second signal is greater than or equal to a bandwidth threshold while the first power amplifier 361 is disabled, control the switching circuit 440 to operate in a first state in which an output of the linear regulator 430 is connected to the first power supply circuit 401. The processor 310 may be configured to, in a case that the second bandwidth of the second signal is smaller than the bandwidth threshold while the first power amplifier 361 is disabled, control the switching circuit 440 to operate in a second state in which an output of the linear regulator 430 is connected to the second power supply circuit 402.

According to an embodiment, the switching circuit 440 may be controlled, in accordance with the processor 310 or the RF transceiver 320, to, in a case that the second bandwidth of the second signal of the second power amplifier is greater than or equal to a bandwidth threshold while the first power amplifier is disabled, operate in a first state in which an output of the linear regulator 430 is connected to the first power supply circuit 401, and in a case that second bandwidth of the second signal is smaller than the bandwidth threshold while the first power amplifier is disabled, operate in a second state in which an output of the linear regulator 430 is connected to the second power supply circuit 402.

According to an embodiment, the power supply module 350 may comprise an envelope input port, a first power supply port, and a second power supply port. The power supply module 350 may be configured to obtain information on an envelope waveform to be inputted to the linear regulator 430 from the RF transceiver 320 through the envelope input port. The power supply module 350 may be configured to supply signals of the first power to the first power amplifier 361 through the first power supply port. The power supply module 350 may be configured to supply signals of the second power to the second power amplifier 362 through the second power supply port.

According to an embodiment, the RF transceiver 320 may be controlled, in accordance with the processor 310, to transmit a first envelope waveform signal to the power supply module 350 through the envelope input port while the first power is provided based on the ET mode using the linear regulator 430 and the first power supply circuit 401, transmit a second envelope waveform signal to the power supply module 350 through the envelope input port while the second power is provided based on the ET mode using the linear regulator 430 and the second power supply circuit 402, and the first envelope waveform signal may be associated with a first signal inputted from the RF transceiver 320 to the first power amplifier, and the second envelope waveform signal may be associated with a second signal inputted from the RF transceiver 320 to the second power amplifier.

According to an embodiment, the processor 310 may be configured to transmit a first envelope waveform signal to the power supply module through the envelope input port while the first power is provided based on the ET mode using the linear regulator 430 and the first power supply circuit 401. The processor 310 may be configured to control the RF transceiver 320 to transmit a second envelope waveform signal to the power supply module through the envelope input port while the second power is provided based on the ET mode using the linear regulator 430 and the second power supply circuit 402. The first envelope waveform signal may be associated with a first signal inputted from the RF transceiver 320 to the first power amplifier 361. The second envelope waveform signal may be associated with a second signal inputted from the RF transceiver 320 to the second power amplifier 362.

According to an embodiment, the electronic device 101 may further comprise a control line connecting between the RF transceiver 320 and the power supply module 350. The first envelope waveform signal or the second envelope waveform signal may be transmitted from the RF transceiver 320 to the power supply module 350 through the control line.

According to an embodiment, the switching circuit 440 may be configured to connect an output of the linear regulator 430 to the first power supply circuit 401 in the first state and to connect an output of the linear regulator 430 to the second power supply circuit 402 in the second state. The power supply module 350 may be configured to, in the first state, provide the first supply voltage 351 according to the ET mode using the linear regulator 430 and the first power supply circuit 401 to the first power amplifier 361 and provide the second supply voltage 352 according to the APT mode using the second power supply circuit 402 to the second power amplifier 362. The power supply module 350 may be configured to, in the second state, provide the first supply voltage 351 according to the APT mode using the first power supply circuit 401 to the first power amplifier 361 and provide the second supply voltage 352 according to the ET mode using the linear regulator 430 and the second power supply circuit 402 to the second power amplifier 362.

According to an embodiment, the power supply module 350 may be configured to receive a control signal indicating one of the first state and the second state from the processor 310 or the RF transceiver 320.

According to an embodiment, the switching circuit 440 may be configured to, in the first state, connect the output of the linear regulator 430 to the first power supply circuit 401 and disconnect the output of the linear regulator 430 and the second power supply circuit 402 while the output of the linear regulator 430 is connected to the first power supply circuit 401. The switching circuit 440 may be configured to, in the second state, connect the output of the linear regulator 430 to the second power supply circuit 402 and disconnect the output of the linear regulator 430 and the first power supply circuit 401 while the output of the linear regulator 430 is connected to the second power supply circuit 402.

According to an embodiment, the first power supply circuit 401 may be connected to at least one first passive element disposed outside the power supply module 350 through a first APT switch in the second state. It may be configured to be disconnected from the at least one first passive element based on an open of the first APT switch in the first state. The second power supply circuit 402 may be connected to at least one second passive element disposed outside the power supply module 350 through a second APT switch in the first state. It may be configured to be disconnected from the at least one second passive element based on an open of the second APT switch in the second state.

According to an embodiment, the first power supply circuit 401 may be configured to operate in an ET mode based on the linear regulator 430 in the first state of the switching circuit 440. The first power supply circuit 401 may be configured to operate in an APT mode without the linear regulator 430 in the second state of the switching circuit 440. The second power supply circuit 402 may be configured to operate in an APT mode without the linear regulator 430 in the first state of the switching circuit 440. The second power supply circuit 402 may be configured to operate in an ET mode based on the linear regulator 430 in the second state of the switching circuit 440.

According to an embodiment, the electronic device 101 may further comprise a first antenna for the first RFFE module, and a second antenna for the second RFFE module. The processor 310 may be configured to transmit a first signal of a first frequency band through the RF transceiver 320, the first RFFE module, and the first antenna. The processor 310 may be configured to transmit a second signal of a second frequency band through the RF transceiver 320, the second RFFE module, and the second antenna, while transmitting the first signal.

According to an embodiment, the electronic device 101 may further comprise a first antenna for the first RFFE module, and a second antenna for the second RFFE module. A first signal of a first frequency band may be transmitted through the RF transceiver 320, the first RFFE module, and the first antenna. A second signal of a second frequency band may be transmitted through the RF transceiver 320, the second RFFE module, and the second antenna, while the first signal is transmitted.

In embodiments, a power supply module 350 is provided. The power supply module 350 may comprise a first power supply circuit 401 including a first buck converter circuit 425 and a first boost converter circuit 420 for the first buck converter circuit 425, a second power supply circuit 402 including a second buck converter circuit 475 and a second boost converter circuit 470 for the second buck converter circuit 475, a linear regulator 430, and a switching circuit 440 configured to selectively operate in one of a first state and a second state based on a control signal. The first boost converter circuit 420 may be configured to provide a regulator voltage to the first linear regulator. The switching circuit 440 may be configured to, in the first state, connect the first buck converter circuit 425 of the first power supply circuit 401 to an output of the linear regulator 430. The switching circuit 440 may be configured to, in the second state, connect the second buck converter circuit 475 of the second power supply circuit 402 to an output of the linear regulator 430.

According to an embodiment, a control circuit configured to receive a control signal indicating one of the first state and the second state from a processor 310 or a radio frequency (RF) transceiver 320 may be further included.

According to an embodiment, the power supply module 350 may comprise an envelope input port, a first power supply port for a first power amplifier 361, and a second power supply port for a second power amplifier 362. The power supply module 350 may be configured to receive information on an envelope waveform to be inputted to the linear regulator 430 from the RF transceiver 320 through the envelope input port. The power supply module 350 may be configured to supply signals of a first power to the first power amplifier 361 through the first power supply port. The power supply module 350 may be configured to supply signals of a second power to the second power amplifier 362 through the second power supply port.

According to an embodiment, in the first state of the switching circuit 440, the signals of the first power may be supplied based on an envelope tracking (ET) mode, and the signals of the second power may be supplied based on an average power tracking (APT) mode. In the second state of the switching circuit 440, the signals of the first power may be supplied based on the APT mode and the signals of the second power may be supplied based on the ET mode.

According to an embodiment, the power supply module 350 may be configured to obtain a first envelope waveform signal through the envelope input port in the first state of the switching circuit 440, and obtain a second envelope waveform through the envelope input port in the second state of the switching circuit 440.

According to an embodiment, the first power supply port may be connected to an output of the first buck converter circuit 425. The second power supply port may be connected to an output of the second buck converter circuit 475. The switching circuit 440 may be configured to selectively connect an output of the linear regulator 430 to an output of the first buck converter circuit 425 or an output of the second buck converter circuit 475.

The processor 120 or 310 of the present disclosure may include various processing circuitries and/or multiple processors. For example, including the claims, the term "processor" as used in the present document may include various processing circuitries comprising at least one processor, and at least one or more of the at least one processor may be configured to individually and/or collectively perform various function(s) described in the present disclosure. As used in the present disclosure, in a case that "processor", "at least one processor", and "one or more processors" are described as being configured to perform various functions, such terms may include, for example without limitation, situations in which a single processor performs the functions, situations in which some of the cited functions are performed by one processor and other functions among the cited functions are performed by other processor(s), situations in which a single processor is capable of performing all of the cited functions, and/or a combination of processors that perform in a distributed manner. In addition, instructions (or program commands) for various function(s) in the present disclosure may, when executed by a processor, cause an electronic device (e.g., the electronic device 101) to execute the various function(s).

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device, comprising;
a processor;
a radio frequency (RF) transceiver;
a first radio frequency front end (RFFE) module including a first power amplifier;
a second RFFE module including a second power amplifier; and
a power supply module including a first power supply circuit for the first power amplifier, a second power supply circuit for the second power amplifier, a linear regulator, and a switching circuit configured to connect an output of the linear regulator to the first power supply circuit or the second power supply circuit selectively,
wherein the switching circuit is controlled, in accordance with the processor or the RF transceiver, to:
in a first state, provide, while providing a first supply voltage to the first power amplifier through the power supply module based on an envelope tracking (ET) mode using the linear regulator and the first power supply circuit, a second supply voltage to the second power amplifier through the power supply module based on an average power tracking (APT) mode using the second power supply circuit, and
in a second state, provide, while providing the first supply voltage to the first power amplifier through the power supply module based on an APT mode using the first power supply circuit, the second supply voltage to the second power amplifier through the power supply module based on an ET mode using the linear regulator and the second power supply circuit.

2. The electronic device of claim 1,
wherein the first power supply circuit includes a first buck converter circuit and a first boost converter circuit for the first buck converter circuit,
wherein the second power supply circuit includes a second buck converter circuit and a second boost converter circuit for the second buck converter circuit,
wherein the first boost converter circuit is configured to supply a regulator voltage to the linear regulator, and
wherein an output of the linear regulator is connected, through the switching circuit, to the first buck converter circuit of the first power supply circuit or to the second buck converter circuit of the second power supply circuit selectively.

3. The electronic device of claim 1, wherein the switching circuit is controlled, in accordance with the processor or the RF transceiver, to:
in a case that a first power of the first power amplifier is greater than a second power of the second power amplifier, operate in a first state in which an output of the linear regulator is connected to the first power supply circuit, and
in a case that the first power is not greater than the second power, operate in a second state in which an output of the linear regulator is connected to the second power supply circuit.

4. The electronic device of claim 1,
wherein the switching circuit is controlled, in accordance with the processor or the RF transceiver, to:
in a case that a first bandwidth of a first signal of the first power amplifier is smaller than a bandwidth threshold and a second bandwidth of a second signal of the second power amplifier is greater than or equal to the bandwidth threshold, operate in a first state in which an output of the linear regulator is connected to the first power supply circuit, and
in a case that the first bandwidth is greater than or equal to the bandwidth threshold and the second bandwidth is smaller than the bandwidth threshold, operate in a second state in which an output of the linear regulator is connected to the second power supply circuit.

5. The electronic device of claim 1, wherein the switching circuit is controlled, in accordance with the processor or the RF transceiver, to:
in a case that the second bandwidth of the second signal of the second power amplifier is greater than or equal to a bandwidth threshold while the first power amplifier is disabled, operate in a first state in which an output of the linear regulator is connected to the first power supply circuit, and
in a case that second bandwidth of the second signal is smaller than the bandwidth threshold while the first power amplifier is disabled, operate in a second state in which an output of the linear regulator is connected to the second power supply circuit.

6. The electronic device of claim 1,
wherein the power supply module comprises an envelope input port, a first power supply port, and a second power supply port, and
wherein the power supply module is configured to:
obtain information on an envelope waveform to be inputted to the linear regulator from the RF transceiver through the envelope input port,
supply signals of the first power to the first power amplifier through the first power supply port, and
supply signals of the second power to the second power amplifier through the second power supply port.

7. The electronic device of claim 6,
wherein the RF transceiver is controlled, in accordance with the processor, to:
transmit a first envelope waveform signal to the power supply module through the envelope input port while the first power is provided based on the ET mode using the linear regulator and the first power supply circuit,
transmit a second envelope waveform signal to the power supply module through the envelope input port while the second power is provided based on the ET mode using the linear regulator and the second power supply circuit,
wherein the first envelope waveform signal is associated with a first signal inputted from the RF transceiver to the first power amplifier, and
wherein the second envelope waveform signal is associated with a second signal inputted from the RF transceiver to the second power amplifier.

8. The electronic device of claim 7, further comprising:
a control line connecting between the RF transceiver and the power supply module,
wherein the first envelope waveform signal or the second envelope waveform signal is transmitted from the RF transceiver to the power supply module through the control line.

9. The electronic device of claim 1,
wherein the switching circuit is configured to connect an output of the linear regulator to the first power supply circuit in the first state and to connect an output of the linear regulator to the second power supply circuit in the second state, and
wherein the power supply module is configured to:
in the first state, provide the first supply voltage according to the ET mode using the linear regulator and the first power supply circuit to the first power amplifier and provide the second supply voltage according to the APT mode using the second power supply circuit to the second power amplifier, and
in the second state, provide the first supply voltage according to the APT mode using the first power supply circuit to the first power amplifier and provide the second supply voltage according to the ET mode using the linear regulator and the second power supply circuit to the second power amplifier.

10. The electronic device of claim 9, wherein the power supply module is configured to receive a control signal indicating one of the first state and the second state from the processor or the RF transceiver.

11. The electronic device of claim 1,
wherein the switching circuit is configured to:
in the first state, connect the output of the linear regulator to the first power supply circuit and disconnect the output of the linear regulator and the second power supply circuit while the output of the linear regulator is connected to the first power supply circuit, and
in the second state, connect the output of the linear regulator to the second power supply circuit and disconnect the output of the linear regulator and the first power supply circuit while the output of the linear regulator is connected to the second power supply circuit.

12. The electronic device of claim 1,
wherein the first power supply circuit is configured to be connected to at least one first passive element disposed outside the power supply module through a first APT switch in the second state and be disconnected from the at least one first passive element based on an open of the first APT switch in the first state, and
wherein the second power supply circuit is configured to be connected to at least one second passive element disposed outside the power supply module through a second APT switch in the first state and be disconnected from the at least one second passive element based on an open of the second APT switch in the second state.

13. The electronic device of claim 1,
wherein the first power supply circuit is configured to:
operate in an ET mode based on the linear regulator in the first state of the switching circuit; and
operate in an APT mode without the linear regulator in the second state of the switching circuit, and
wherein the second power supply circuit is configured to:
operate in an APT mode without the linear regulator in the first state of the switching circuit; and
operate in an ET mode based on the linear regulator in the second state of the switching circuit.

14. The electronic device of claim 1, further comprising:
a first antenna for the first RFFE module; and
a second antenna for the second RFFE module,
wherein a first signal of a first frequency band through the RF transceiver, the first RFFE module, and the first antenna is transmitted, and
wherein a second signal of a second frequency band through the RF transceiver, the second RFFE module, and the second antenna is transmitted, while the first signal is transmitted.

15. A power supply module comprising:
a first power supply circuit including a first buck converter circuit and a first boost converter circuit for the first buck converter circuit;
a second power supply circuit including a second buck converter circuit and a second boost converter circuit for the second buck converter circuit;
a linear regulator; and
a switching circuit configured to operate in one of a first state and a second state based on a control signal,
wherein the first boost converter circuit is configured to provide a regulator voltage to the first linear regulator, and
wherein the switching circuit is configured to:
in the first state, connect the first buck converter circuit of the first power supply circuit to an output of the linear regulator, and
in the second state, connect the second buck converter circuit of the second power supply circuit to an output of the linear regulator.
